**Europäisches Patentamt**

**European Patent Office**

**Office européen des brevets**

(19)

(11) Veröffentlichungsnummer: **0 199 202**
**B1**

(12) **EUROPÄISCHE PATENTSCHRIFT**

(45) Veröffentlichungstag der Patentschrift:
**18.10.89**

(51) Int. Cl.⁴: **G01N 24/08**

(21) Anmeldenummer: **86104942.7**

(22) Anmeldetag: **10.04.86**

(54) Kernspinresonanzgerät.

(30) Priorität: **22.04.85 DE 3514530**

(43) Veröffentlichungstag der Anmeldung:
**29.10.86 Patentblatt 86/44**

(45) Bekanntmachung des Hinweises auf die Patenterteilung:
**18.10.89 Patentblatt 89/42**

(84) Benannte Vertragsstaaten:
**DE FR GB NL**

(56) Entgegenhaltungen:
**EP-A- 0 145 932**
**GB-A- 2 126 731**
**GB-A- 2 148 013**

**IEEE TRANSACTIONS ON MEDICAL IMAGING, Band MI-3, Nr. 1, März 1984, Seiten 41-46, New York, US; H. IWAOKA et al.: "A new pulse sequence for "fast recovery" fast-scan NMR imaging"**

(73) Patentinhaber: **Siemens Aktiengesellschaft, Wittelsbacherplatz 2, D-8000 München 2(DE)**

(72) Erfinder: **Graumann, Rainer, Dr., Lucas-Cranach-Str.39, D-8552 Höchstadt(DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Kernspinresonanzgerät zur Untersuchung eines Objektes mit Hilfe der kernmagnetischen Resonanz, mit Spulen zum Anlegen von magnetischen Grund- und Gradientenfeldern an das Untersuchungsobjekt und einer Hochfrequenzeinrichtung, die das Untersuchungsobjekt mit einer Folge von Hochfrequenzpulsen bestrahlt und die von dem Untersuchungsobjekt abgestrahlten Kernresonanzsignale erfaßt.

Ein Gerät dieser Art ist in der deutschen Offenlegungsschrift 3 135 335 beschrieben. Dieses Gerät bietet die Möglichkeit, die magnetischen Kernmomente (Kernspins) eines Untersuchungsobjektes aus einer Vorzugsrichtung, die durch ein magnetisches Grundfeld festgelegt wird, mit Hilfe eines Hochfrequenzpulses auszulenken. Die dazu erforderliche Frequenz $\omega_0$ ist über die Gleichung $\omega_0 = \gamma.B_0$ durch das gyromagnetische Verhältnis $\gamma$ (charakteristische Größe für die betrachteten Atomkerne) und die magnetische Flußdichte $B_0$ des Grundfeldes festgelegt. Nach der Einwirkung des Hochfrequenzfeldes strebt das System der Kernspins unter Aussendung von Kernresonanzsignalen wieder dem Grundzustand entgegen. Die Stärke des gemessenen Resonanzsignales ist proportional zur Anzahl der angeregten Kernspins und erlaubt somit Rückschluß auf die Spindichte des Untersuchungsobjektes.

Liegen die Atomkerne, deren Resonanz man beobachtet, in verschiedenen chemischen Bindungszuständen vor, so ergeben sich aufgrund der unterschiedlichen lokalen Magnetfelder am Ort dieser Kerne auch unterschiedliche Resonanzfrequenzen. Die Intensitätsverhältnisse der zugehörigen Resonanzlinien zeigen in diesem Fall die relative Häufigkeit an, mit denen die untersuchten Kerne in den verschiedenen Bindungszuständen vorzufinden sind.

Um ein Kernresonanzsignal nicht aus dem gesamten Untersuchungsobjekt, sondern nur aus einem bestimmten vorgegebenen Volumenbereich zu erhalten, werden lediglich die Kernspins in dem interessierenden Volumenbereich angeregt. Die Auswahl dieses Bereiches (in der Regel wählt man Ebenen) wird durch Überlagerung eines geeigneten magnetischen Gradientenfeldes über das Grundfeld erreicht. Das hierdurch resultierende inhomogene (z.B. in Z-Richtung linear ansteigende), magnetische Feld läßt bei Anwendung eines selektiven Hochfrequenzpulses die Anregung nur noch derjenigen Kerne zu, bei denen das magnetische Feld den für die obige Resonanzbedingung erforderlichen Wert besitzt (im Beispiel eine Schicht senkrecht zur Gradientenrichtung (Z-Richtung)). Um die Beiträge der verschiedenen Kerne zum Resonanzsignal innerhalb einer angeregten Ebene zu unterscheiden, schaltet man nach erfolgter Anregung das Gradientenfeld senkrecht zur Schicht aus und stattdessen einen Feldgradienten ein, dessen Richtung in der Schichtebene liegt (z.B. X-Richtung). Aufgrund der unterschiedlichen magnetischen Feldstärken präzedieren die Kerne der angeregten Schicht verschieden schnell und emittieren daher Resonanzsignale mit unterschiedlichen Frequenzen. Aus dem resultierenden empfangenen Signal $S(t)$ können durch Fouriertransformationen ($S(t) \to S(\omega)$)das Spektrum $S(\omega)$ und damit die Frequenzanteile des Signales erhalten werden. Durch dieses Frequenzspektrum $S(\omega)$ können also die verschiedenen Beiträge der Kerne zum Signal aufgrund ihrer Frequenz dem Ort ihrer Enstehung zugeordnet werden. Im Beispiel tragen alle Kerne in einem Streifen senkrecht zur X-Richtung mit derselben Frequenz zum Gesamtsignal bei, weil diese die gleiche Stärke des Magnetfeldes erfahren. Man erhält somit eine Projektion der Spindichte auf die Richtung des geschalteten Gradienten.

Um ein Bild der angeregten Schicht konstruieren zu können, muß noch die Abhängigkeit des Resonanzsignales von der dritten Raumrichtung (im Beispiel Y-Richtung) ermittelt werden. Hierzu kann man

a) die oben beschriebenen Messungen für viele Projektionsrichtungen (geeignete Kombinationen der X- und Y-Gradienten) wiederholen und aus den gewonnenen Meßdaten ein Spindichtebild der angeregten Schicht durch Rückprojektion konstruieren, oder

b) die mit Hilfe bestimmter Kombinationen der X- und Y-Gradientenfelder aufgenommene zweidimensionale Meßmatrix einer zweidimensionalen Fouriertransformation unterziehen.

Das von den untersuchten Kernen emittierte Kernresonanzsignal ist in der Amplitude nicht nur von der Spindichte des angeregten Bereiches, sondern unter anderem auch von der Spin-Gitter-Relaxation, Spin-Spin-Relaxation und den Feldinhomogenitäten abhängig. Man kann sich die Einflüsse der vorgenannten Parameter in einem vereinfachenden Kreiselmodell vorstellen, bei dem die Kernspins des Untersuchungsobjektes durch rotierende magnetische Momente (Kreisel) in einem magnetischen Grundfeld symbolisiert sind. Das Grundfeld soll dabei in Z-Richtung orientiert sein. In diesem Modell dreht das auf die Kernspins des Untersuchungsobjektes einwirkende magnetische Wechselfeld des Anregungspulses diese um einen bestimmten Winkel (Flipwinkel) aus der Z-Richtung heraus. Im Falle eines 90°-Pulses liegen alle Spins nach der Anregung parallel ausgerichtet innerhalb der X-Y-Ebene. Die sich anschließende Präzessionsbewegung der magnetischen Momente wird begleitet durch

1. die Spin-Spin-Relaxation (Wechselwirkung der Spins untereinander führt zu einer Abnahme der Magnetisierungskomponente in der X-Y-Ebene (Quermagnetisierung) mit der Zeitkonstanten $T_2$ im Rahmen des oben beschriebenen Modells),

2. die Spin-Gitter-Relaxation (Wechselwirkung der Spins mit dem Gitter führt zur Rückkehr der Magnetisierung in den Ausgangszustand parallel zum Feld mit der Zeitkonstanten $T_1$),

3. Feldinhomogenitäten (bewirken ein Auseinanderlaufen der aus diesem Grunde mit verschiedenen Frequenzen präzedierenden Kreiselspins bezüglich der X-Y-Ebene).

Im allgemeinen gilt für die Relaxationszeiten $T_1$ und $T_2$: $T_1 > T_2$. Die Amplitude des von den angeregten Kernen ausgesandten Signales (FID-Signal, free induction decay signal) ist unter anderem von der resultierenden Magnetisierungskomponente in der X-Y-Ebene bestimmt. Mehr als noch die Spin-Spin-Relaxation bewirkt das durch Feldinhomogenitäten bedingte Dephasieren der Spins die Abnahme dieser Komponente. Die durch beide Prozesse verursachte Abnahme der Quermagnetisierung wird oft mit der Zeitkonstanten $T_2^*$ beschrieben.

Da die durch Feldinhomogenitäten verursachte Dephasierung für jeden Ort ein fest vorgegebenes Zeitverhalten aufweist, kann dieser Prozeß durch geeignete Maßnahmen weitgehend umgekehrt werden (Refokussierung, z.B. durch einen $\pm$ 180°-Hochfrequenzpuls).

Man beobachtet ein Anwachsen der Amplitude des Resonanzsignales zu einem Maximum (Spin-Echo), bei der die durch Feldinhomogenität verursachte Dephasierung weitgehend kompensiert ist und schließlich wieder ein Abfallen der Amplitude mit der Zeitkonstanten $T_2^*$ aufgrund der erneuten Dephasierung. Dieser Fokussierungsprozeß ist wiederholt anwendbar (z.B. durch Folge von $\pm$ 180°-Pulsen) und führt zu weiteren Echos. Die zeitliche Abnahme der Stärke (Maximalamplituden) dieser Echos gibt daher Aufschluß über die Relaxationskonstante $T_2$.

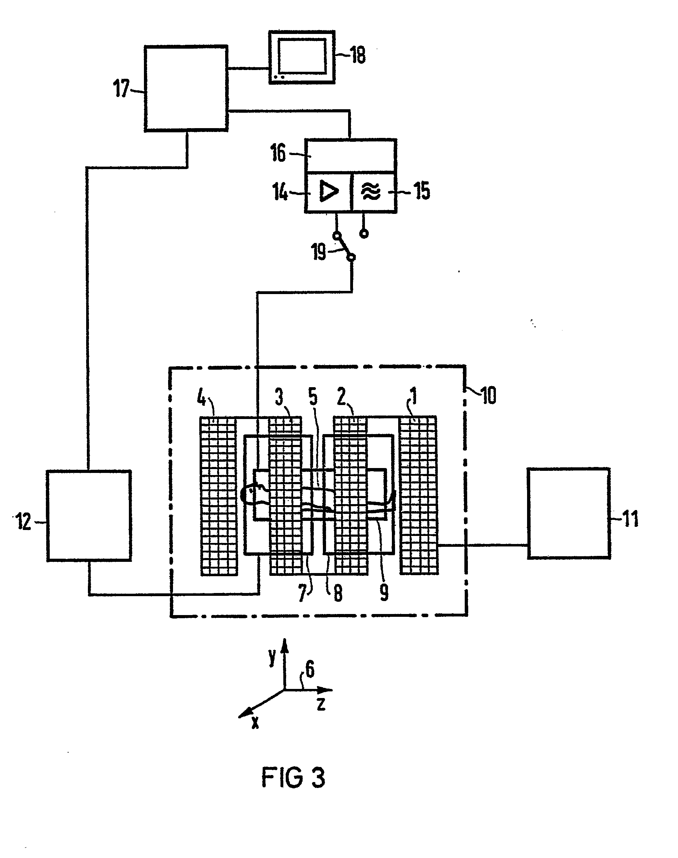

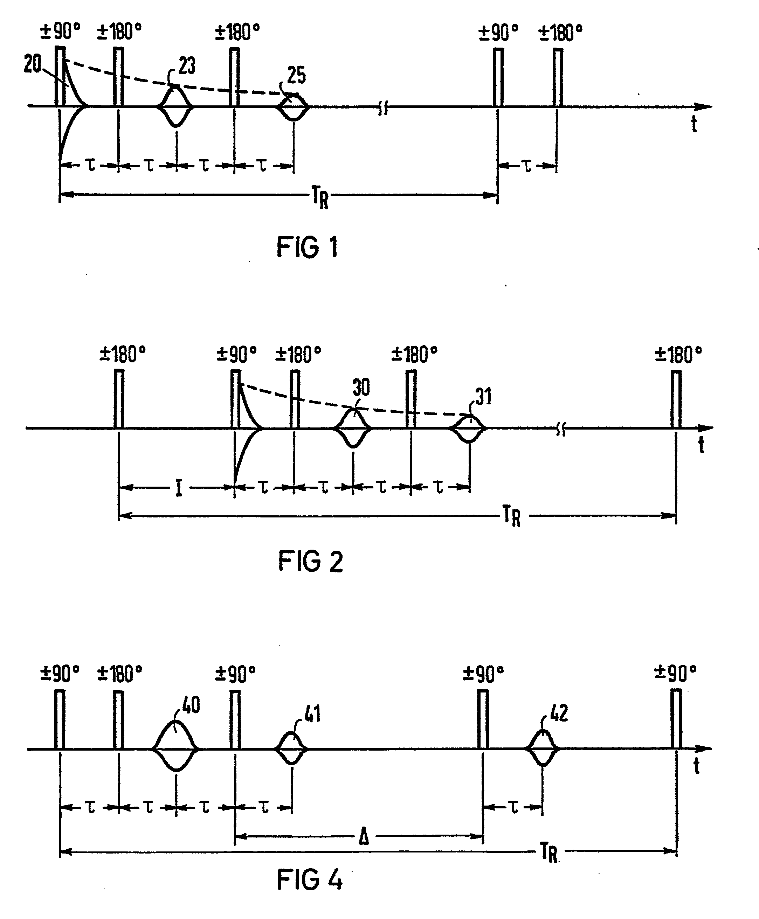

Das sogenannte Spin-Echo-Verfahren benutzt eine Pulssequenz der beschriebenen Art (Fig. 1). Nachdem das FID-Signal 20 des ersten $\pm$ 90°-Pulses abgeklungen ist, wird durch den ersten $\pm$ 180°-Puls die Refokussierung eingeleitet. Nach der Zeit 2 $\tau$ (gerechnet vom Zeitpunkt des ersten $\pm$ 90°-Pulses) ist eine maximale Fokussierung erreicht (Maximalamplitude des ersten Spin-Echos 23). Die danach eintretende Dephasierung wird wegen eines weiteren $\pm$ 180°-Pulses wieder in eine Refokussierung umgekehrt. Durch die Refokussierung entsteht ein zweites Spin-Echo 25 zum Zeitpunkt 4 $\tau$ jedoch mit geringerer Maximalamplitude, da in der Zwischenzeit zufällige, zeitlich irreversible Spin-Spin-Wechselwirkungen eine Abnahme der Magnetisierung in der X-Y-Ebene zur Folge hatten. Nach einer Zeit $T_R$ beginnt die nächste Pulssequenz mit einem $\pm$ 90°-Puls.

Der zeitliche Verlauf des ersten Echosignales 23 S1(t) wird durch das Kernspinresonanzgerät abgespeichert und stellt eine Zeile einer zweidimensionalen Meßmatrix dar. Entsprechend bildet das abgespeicherte Signal S2(t) des zweiten Echos 25 ebenfalls eine Zeile einer zweiten zweidimensionalen Meßmatrix. Mit jeder Sequenz werden bei entsprechender Wahl der Gradientenfelder andere Zeilen der beiden Meßmatrizen eingelesen. Im Falle der Bildrekonstruktion nach Verfahren b) wird dann jede der so erhaltenen vollständigen Meßmatrizen durch eine zweidimensionale Fouriertransformation in ein Ergebnisbild umgerechnet.

Die Figur 2 zeigt eine Pulssequenz, wie sie beim "inversion recovery"-Verfahren benutzt wird. Diese Pulssequenz gleicht der Spin-Echo-Sequenz bis auf einen vorangestellten $\pm$ 180°-Puls. Dieser Puls bewirkt im Zusammenhang mit der Wahl einer bestimmten Zeitdifferenz I eine stärkere $T_1$-Betonung der auf diese Weise aus den Spin-Echos 30 und 31 gewonnenen Bilder.

Unter bestimmten Bedingungen treten bei der Verwendung von Pulssequenzen mit drei oder mehr HF-Pulsen unter anderem sogenannte stimulierte Echos auf, die ihre Ursache im Falle einer Pulssequenz mit drei aufeinanderfolgenden 90°-Pulsen in der nach dem zweiten 90°-Puls vorhandenen Z-Komponente der Magnetisierung haben.

Verfahren, bei denen stimulierte Echosignale erzeugt werden, sind erstmals in der Veröffentlichung von E.L. Hahn, "Phys. Rev." 80 (1950), Seite 580, beschrieben worden. Da die im stimulierten Echosignal enthaltenen Informationen ebenfalls für die bildgebende Kernspinresonanz ausgewertet werden können, ist es das Ziel der vorliegenden Erfindung, dieses stimulierte Echo innerhalb einer Pulssequenz zu erzeugen, und die Echoinformationen zum Beispiel zur Erstellung eines zusätzlichen $T_1$-betonten Bildes zu benutzen.

Da in der MR-Bildgebung die Spindichte $\rho$ die Relaxationszeiten $T_1$ und $T_2$ wichtige Parameter bei der Gewebecharakterisierung sind, ist man bestrebt, in kurzer Zeit möglichst viele Informationen über sie zu erhalten. Bisher konnten unterschiedliche $T_1$- und $T_2$-betonte Bilder in einer Sequenz nicht gewonnen werden. Es bestand nur die Möglichkeit, in mehreren Meßsequenzen die gewünschten Informationen zu erhalten.

In der GB-A 2 126 731 sind Vorrichtungen und Verfahren zur Bildgebung mit Hilfe der kernmagnetischen Resonanz beschrieben. Dabei wird durch eine Pulssequenz 90°, $\tau$, 180°, $\tau$, 90° erreicht, daß die nötige Relaxationszeit zwischen zwei aufeinanderfolgen den Sequenzen erheblich reduziert wird, da die Kernspins durch den dritten Puls (90°) in einen Magnetisierungszustand versetzt werden, der demjenigen im Zustand des thermischen Gleichgewichtes sehr nahekommt.

In dem Artikel "IEEE Transactions on Medical Imaging", Vol. MI–3, Nr. 1, März 1984, Seiten 41–46, ist eine Pulssequenz 90°, $T_{S1}$, 180°, $T_{S2}$, 90°, 180°, $T_d$ beschrieben. Auch hier wird durch den 180°-Puls nahezu ein Rücksetzen in den thermischen Gleichgewichtszustand erreicht. Ausgelesen werden das FID-Signal und das 180°-Spin-Echo. Ein stimuliertes Echo kann mit dieser Sequenz nicht erzeugt werden.

Der Erfindung liegt die Aufgabe zugrunde, ohne Verlängerung der Meßzeit in einer Meßsequenz neben den Informationen für ein herkömmliches Spin-Echo-Bild auch Informationen für ein $T_1$-betontes Bild und ein $T_2$-betontes Spin-Echo-Bild zu erhalten.

Diese Aufgabe ist erfindungsgemäß dadurch gelöst, daß die Hochfrequenzeinrichtung (9 und 16) so ausgebildet ist, daß die von ihr erzeugten Hochfrequenzpulse und die von den Hochfrequenzpulsen erzeugten Echos innerhalb einer Sequenz in folgender zeitlicher Abfolge auftreten:

a) Hochfrequenzpuls mit einem Flipwinkel von etwa ± 90° zum Zeitpunkt 0,
b) Hochfrequenzpuls mit einem Flipwinkel von etwa ± 180° zum Zeitpunkt $\tau$,
c) ± 180°-Spin-Echo 40 zum Zeitpunkt 2 $\tau$,
d) Hochfrequenzpuls mit einem Flipwinkel von etwa ± 90° zum Zeitpunkt 3 $\tau$,
e) ± 90°-Spin-Echo 41 zum Zeitpunkt 4 $\tau$,
f) Hochfrequenzpuls mit einem Flipwinkel von etwa $\tau$ 90° zu einem Zeitpunkt 3 $\tau$ + $\Delta$, und
g) stimuliertes Echo (42) zum Zeitpunkt 4 $\tau$ + $\Delta$.

Diese Pulsfolge ermöglicht die Aufnahme von drei Bildern mit jeweils unterschiedlichem Informationsgehalt. Es handelt sich dabei um das aus den herkömmlichen Sequenzen bekannte Spin-Echo-Bild, ein $T_2$-betontes Spin-Echo-Bild und ein $T_1$-betontes Bild (aus dem stimulierten Echo.)

Die Erfindung ist nachfolgend anhand der Figuren 3 und 4 näher erläutert: Es zeigen:

Fig. 3 das Blockschaltbild der wesentlichen Teile eines Kernspinresonanzgerätes, und
Fig. 4 eine Pulssequenz gemäß der Erfindung.

In der Figur 3 sind mit 1 und 2 sowie 3 und 4 Spulen gekennzeichnet, mit welchen ein magnetisches Grundfeld $B_0$ erzeugt wird, in welchem sich bei Anwendung zur medizinischen Diagnostik der zu untersuchende Körper 5 eines Patienten befindet. Diesem sind außerdem Gradientenspulen zugeordnet, die zur Erzeugung unabhängiger, zueinander senkrechter Magnetfeldgradienten der Richtungen X, Y und Z gemäß der Andeutung in 6 vorgesehen sind. In der Figur sind der Übersichtlichkeit halber nur Gradientenspulen 7 und 8 gezeichnet, die zusammen mit einem Paar gegenüberliegender, gleichartiger Gradientenspulen zur Erzeugung des X-Gradienten dienen. Die gleichartigen, nicht gezeichneten Y-Gradientenspulen liegen parallel zum Körper 5 und oberhalb sowie unterhalb von ihm und die für das Z-Gradientenfeld quer zu seiner Längsachse am Kopf- und am Fußende. Die Anordnung enthält außerdem noch eine zur Erzeugung und Aufnahme der Kernresonanzsignale dienende Spule 9.

Die von einer strichpunktierten Linie 10 umgrenzten Spulen 1 bis 9 stellen das eigentliche Untersuchungsinstrument dar. Es wird von einer elektrischen Anordnung aus betrieben, die ein Netzgerät 11 zum Betrieb der Spulen 1 bis 4 sowie eine Gradientenstromversorgung 12, an welcher die Gradientenspulen 7 und 8 sowie die weiteren Gradientenspulen liegen, umfaßt. Die Meßspule 9 liegt über einen Signalverstärker 14 bzw. einen Hochfrequenzsender 15 an einem Prozeßrechner 17, von dem aus zur Ausgabe der Abbildung ein Bildschirmgerät 18 versorgt wird. Die Komponenten 14 und 15 bilden eine Hochfrequenzeinrichtung 16 zur Signalerzeugung und -aufnahme. Ein Umschalter 19 ermöglicht das Umschalten von Sende- auf Empfangsbetrieb.

Die Figur 4 zeigt die bei der erfindungsgemäßen Pulssequenz auftretenden Echosignale für den Fall, daß als vierter Hochfrequenzpuls ein ± 90°-Puls verwendet wird. Hinter dem ± 180°-Puls entsteht das von den herkömmlichen Sequenzen bekannte Spinecho 40 mit der Amplitude

$$S_1 \sim \; S \cdot \exp(-2\tau/T_2) \cdot \underbrace{(1-\exp(-(T_R-\Delta-3\tau)/T_1))}_{F}$$

Das 90°-Spinecho 41 besitzt die Maximalamplitude

$$S_2 \sim (S/2) \cdot \exp(-4\tau/T_2) \cdot F$$

und liefert Informationen für ein $T_2$-betontes Bild. Nach der Zeit $4\tau$ + $\Delta$ entsteht hinter dem vierten Hochfrequenz-Puls ein stimuliertes Echo mit der Maximalamplitude

$$S_3 \sim (S/2) \cdot \exp(-4\tau/T_2) \cdot \exp(-\Delta/T_1) \cdot F,$$

welches Informationen für ein $T_1$-betontes Bild enthält. Die aus den Echos 40, 41, 42 gewonnenen Informationen erlauben eine Bestimmung der $T_1$ und $T_2$ Relaxationskonstanten in einer Sequenz. Da die zusätzlich gewonnenen Informationen zusammen mit der Spinechoinformation in einer Sequenz gewonnen werden, ist keine Verlängerung der Meßzeit gegenüber dem herkömmlichen Spinechoverfahren erforderlich. Durch die erfindungsgemäße Vierpuls-Sequenz wird somit die oben gestellte Aufgabe gelöst.

Eine sinnvolle Weiterentwicklung der beschriebenen Pulssequenz ergibt sich beispielsweise durch Anfügung einer Serie von ± 180°-Pulsen, die weitere Informationen für $T_2$-betonte Bilder liefern kann.

Verwendet man in Schritt f) anstatt des Pulses mit Flipwinkel ± 90° einen Puls mit einem Flipwinkel $\alpha$, wobei $|\alpha|$ kleiner 90° ist, so wird nach diesem Puls nur ein Bruchteil des stimulierten Echossignales ausgelesen (Teilauslesepuls). Mit Hilfe einer Erweiterung der Sequenz durch Anfügung weiterer Teilauslesepulse lassen sich wiederum zusätzliche Informationen für Bilder mit unterschiedlicher $T_1$-Betonung gewinnen.

Schließlich lassen sich durch Kombination aller durch die erfindungsgemäße Sequenz gewonnenen Informationen zusätzliche Bilder erzeugen.

## Patentansprüche

1. Kernspinresonanzgerät zur Untersuchung eines Objektes (5) mit Hilfe der kernmagnetischen Resonanz, mit Spulen (1, 2, 3, 4, 7, 8) zum Anlegen von magnetischen Grund- und Gradientenfeldern an das Untersuchungsobjekt (5) und einer Hochfrequenzeinrichtung (9 und 16), die das Untersuchungsobjekt (5) mit einer Folge von Hochfrequenzpulsen (Pulssequenz) bestrahlt und die von den Kernspins des Untersuchungsobjektes (5) abgestrahlten Kernresonanzsignale (40, 41, 42) empfängt, dadurch gekennzeichnet, daß die Hochfrequenzeinrichtung (9 und 16) so ausgebildet ist, daß die von ihr erzeugten Hochfrequenzpulse und die von den Hochfrequenzpulsen erzeugten Echos innerhalb einer Sequenz in folgender zeitlicher Abfolge auftreten:

a) Hochfrequenzpuls mit einem Flipwinkel von etwa ± 90° zum Zeitpunkt 0,
b) Hochfrequenzpuls mit einem Flipwinkel von etwa ± 180° zum Zeitpunkt $\tau$,
c) ± 180° -Spin-Echo (40) zum Zeitpunkt $2\tau$,
d) Hochfrequenzpuls mit einem Flipwinkel von etwa ± 90° zum Zeitpunkt $3\tau$,
e) ± 90°-Spin-Echo (41) zum Zeitpunkt $4\tau$,
f) Hochfrequenzpuls mit einem Flipwinkel von etwa ± 90° zu einem Zeitpunkt $3\tau + \Delta$, und
g) stimuliertes Echo (42) zum Zeitpunkt $4\tau + \Delta$.

2. Kernspinresonanzgerät nach Anspruch 1, dadurch gekennzeichnet, daß in Schritt f) anstatt des Pulses mit Flipwinkel ± 90° mindestens ein Puls mit einem Flipwinkel $\alpha$ auftritt, wobei $|\alpha|$ kleiner 90° ist (Teilauslesepuls).

## Claims

1. Nuclear spin resonance device for examination of an object (5) by means of nuclear magnetic resonance, with coils (1, 2, 3, 4, 7, 8) for application of magnetic fundamental and gradient fields to the; object of examination (5) and with a high-frequency device (9 and 16) which exposes the object of examination (5) to a sequence of high-frequency pulses (pulse sequence) and receives the nuclear resonance signals (40, 41, 42) radiated from the nuclear spins of the object of examination (5), characterized in that the highfrequency device (9 and 16) is designed so that the high-frequency pulses generated by the device and the echoes generated by the high-frequency pulses occur, within a sequence, in the following sequence in time:

a) High-frequency pulse with a flip angle of approximately ± 90° at time 0,
b) High-frequency pulse with a flip angle of approximately ± 180° at time $\tau$,
c) ± 180° spin echo (40) at time $2\tau$,
d) High-frequency pulse with a flip angle of approximately ± 90° at time $3\tau$,
e) ± 90° spin echo (41) at time $4\tau$,
f) High-frequency pulse with a flip angle of approximately ± 90° at a time $3\tau + \Delta$, and
g) Stimulated echo (42) at time $4\tau + \Delta$.

2. Nuclear spin resonance device as in Claim 1, characterized in that in stage f), instead of the pulse with a flip angle of ± 90°, at least one pulse with a flip angle $\propto$ is produced, wherein $|\alpha|$ is less than 90° (partial read out pulse).

## Revendications

1. Appareil de résonance de spin nucléaire pour examiner un objet (5) à l'aide de la résonance magnétique nucléaire, comprenant des bobines (1, 2, 3, 4, 7, 8) pour appliquer des champs magnétiques de base et de gradients à l'objet examiné (5) et un dispositif à haute fréquence (9 et 16) qui irradie l'objet examiné (5) avec un train d'impulsions haute fréquence (séquence d'impulsions) et qui reçoit les signaux de résonance magnétique nucléaire (40, 41, 42) émis par les spins nucléaires de l'objet examiné (5), caractérisé en ce que le dispositif à haute fréquence (9 et 16) est réalisé de manière que les impulsions haute fréquence qu'il génère et les échos produits par les impulsions à haute fréquence apparaissent, en une séquence, dans l'ordre chronologique suivant:

a) impulsion haute fréquence avec un angle de basculement d'environ $\pm$ 90° à l'instant 0,

b) impulsion haute fréquence avec un angle de basculement d'environ $\pm$ 180° à l'instant $\tau$,

c) écho de spin (40) à $\pm$ 180° à l'instant 2 $\tau$;

d) impulsion haute fréquence avec un angle de basculement d'environ $\pm$ 90° à l'instant 3 $\tau$,

e) écho de spin (41) à $\pm$ 90° à l'instant 4 $\tau$,

f) impulsion haute fréquence avec un angle de basculement d'environ $\pm$ 90° à un instant 3 $\tau$ + $\Delta$, et

g) écho stimulé (42) à l'instant 4 $\tau$ + $\Delta$.

2. Appareil selon la revendication 1, caractérisé en ce que, dans la phase f), il apparaît, à la place de l'impulsion avec l'angle de basculement de $\pm$ 90°, au moins une impulsion avec un angle de basculement $\alpha$, $|\alpha|$ étant inférieur à 90° (impulsion de lecture partielle).

FIG 3

±90° ±180° ±180° ±90° ±180°

20 23 25

τ τ τ τ τ

$T_R$

FIG 1

±180° ±90° ±180° ±180° ±180°

30 31

I τ τ τ τ

$T_R$

FIG 2

±90° ±180° ±90° ±90° ±90°

40 41 42

τ τ τ τ τ

Δ

$T_R$

FIG 4